# EUROPEAN PATENT APPLICATION

(11) **EP 2 770 069 A1**
(43) Date of publication of application: **27.08.2014**
(21) Application number: 13155873.6
(22) Date of filing: 20.02.2013
(51) Int. Cl.: C22C 1/05, C04B 35/58, C22C 29/18, H01L 35/22

(54) **Quinary Mg2Si-based n-type thermoelectric materials, methods for their preparation and thermoelectric devices using such materials**

(71) Applicant: University Of Cyprus, 2109 Nicosia (CY)
(72) Inventor: Karatsi, Theodora, 2109 Nicosia (CY); Khan, Atta Ullah, 2109 Nicosia (CY)
(74) Representative: Plougmann & Vingtoft A/S

(57) **Abstract**

Quinary n-type thermoelectric materials are presented with the formula Mg₂Si_{0.6+x-y-z}Sn_{0.4-x} Ge_{y}M_{z}, wherein M may be Bi or Sb or a mixture of Bi and Sb, and wherein 0≤x≤0.25, 0<y<0.15 and 0.005≤z≤0.03. Such materials have are shown to have ZT values as high as 1.5. Powder routes for making such materials are also disclosed.

## Description

### TECHNICAL FIELD OF THE INVENTION

The present invention relates to thermoelectric power conversion for waste heat capture. In particular, the present invention relates to thermoelectric materials based on Mg₂Si and powder-processing routes for fabricating such materials.

### BACKGROUND OF THE INVENTION

Recovery of energy is global a challenge that has spurred development of thermoelectric ("TE") technology. Waste heat, emitted as a by-product of various processes, including operation of cars, trucks/buses, aircraft aero-engines, factories and industrial plants, can be converted into useful electrical energy using TE technology. Solar thermal energy can also be converted into electricity via systems that combine TE and photovoltaic devices. Tritt et al., MRS Bulletin, vol. 33, 366 (2008).

The TE materials used in TE devices are mainly semiconductors. In order to be economically viable, TE materials should combine high electrical conductivity (σ), high Seebeck coefficient (S) and low thermal conductivity (κ), so that the figure-of merit ZT=σS²T/κ exceeds at least 1. However, these parameters are not independent of each other so the optimization process can be complex and difficult. Further, for many TE materials, including nano-structured materials, the TE properties of a material with a given composition cannot easily be predicted from first principles.

In nano-structured TE materials, i.e., materials with structural dimensions smaller than the phonon mean free path but larger than those of electrons and holes, enhanced phonon scattering at grain boundaries is believed to reduce κ more rapidly than σ, while quantum confinement and low-energy carrier scattering effects (carrier filtering) are believed to enhance the power factor, σS², leading to an increase ZT. Powder routes may be used to fabricate nano-structured TE materials at relatively low cost.

The TE materials used in commercial devices typically have ZT values of about 1 at relevant operating temperatures. Commercial TE materials have traditionally included tellurides, especially Bi₂Te₃ and PbTe-based materials, with much recent effort also being directed towards development of skutterudites and silicides. At a research level, some materials have shown ZT values higher than 1.5. However, lead- and tellurium-based materials have high toxicity and high environmental impact, and their constituents are resource limited. Skutterudites present promising properties but the cost of the constituent elements is generally high.

Of the silicides, Mg₂Si-based TE materials are promising for heat conversion in the mid-temperature range because of their attractive ZT values, low density, low cost, non-toxicity and high abundance of constituents in earth's crust. Mg₂(Si,Sn) and Mg₂(Si,Ge) solid-solution-based TE materials have shown relatively high ZT values. In these compounds, Sb and Bi may act as n-type dopants and Li and Ag as p-type dopant. A ZT of 1.1 has been reported for Mg₂Si₁₋ₓSnₓ-based materials, Zailtsev, et al., Physical Review B, vol. 74, p 45207 (2006); Zhang, et al, Applied Physics Letters, vol. 93, no. 10, art. no. 102109 (2008), and ZT of 0.86 with Bi doping. Tani, et al., Physica B, vol. 364, p 218 (2005).

Recently, quaternary Mg₂Si-based materials have also been developed, including Mg₂Sn_{0.4}Si_{0.6-x}Geₓ. Yin et al., Int'l J. Minerals, Metal. & Materials, Vol. 16 No. 5, p 565 (October 2009). However, such materials are reported as having ZT values of less than 0.28.

Improved TE materials and methods for the manufacture of such materials would be advantageous, in particular economically viable methods for manufacturing materials with high ZT values from constituents that are neither resource limited nor present environmental issues.

### OBJECTS OF THE INVENTION

It is an object of the present invention to provide n-type Mg₂Si-based materials with improved ZT values.

It is another object of the present invention to provide an economically viable process for fabricating n-type Mg₂Si-based materials with improved ZT values, using constituents that are neither resource limited nor present environmental issues.

It is another object of the present invention to provide a TE device comprising n-type Mg₂Si-based materials with improved ZT values.

It is a further object of embodiments of the invention to provide alternatives to the prior art.

### SUMMARY OF THE INVENTION

In an aspect of the invention, an n-type quinary Mg₂Si-based material is provided which is represented by the chemical formula Mg₂Si_{0.6+x-y-z}Sn_{0.4-x}Ge_{y}M_{z}, wherein M is Bi, Sb or a mixture of Bi and Sb, and wherein 0≤x≤0.25, 0<y≤0.15 and 0.005≤z≤0.03.

In another aspect of the invention, a powder-based processing route for making such n-type quinary Mg₂Si-based materials is presented comprising the following steps: Mixing powders of the elements in proportions appropriate for the desired composition; Cold pressing the mixed powders; Heating to temperatures in the range of 600 to 700°C and cooling to room temperature; Ball milling the heat treated material; Repeating the cold pressing and heating steps at least once; and Hot-pressing at temperatures in the range of 700 to 800°C in the range of 50-100 MPa.

In another aspect of the invention, such n-type quinary Mg₂Si-based materials may be incorporated into a thermoelectric device.

An advantage of such n-type quinary Mg₂Si-based materials is improved ZT values over currently available Mg₂Si-based materials, including pristine Mg₂Si, and Mg₂Si₁₋ₓSnₓ, Mg₂Si₁₋ₓGeₓ and Mg₂Si_{0.6-x}Sn_{0.4}Geₓ solid solutions.

Another advantage of such n-type quinary Mg₂Si-based materials is that the constituents are not resource limited and are available in commercially useful quantities.

Another advantage of such n-type quinary Mg₂Si-based materials is that they are non-toxic and potentially compliant with REACH and RoHS obligations.

Other advantages of such n-type quinary Mg₂Si-based materials is that they can be operated in the temperature range 300-550°C, a range which is important for waste heat recovery.

Yet other advantages such n-type quinary Mg₂Si-based materials is their very low density, less than 3 g/cm³, which is especially suitable for transportation applications, good corrosion resistance, high mechanical strength, and isotropic thermoelectric properties due to cubic antifluorite crystal structure (Fm3m).

A further advantage is that the powder-based processing methods may be scaled to produce the desired quantities of such n-type quinary Mg₂Si-based materials in appropriate sizes and shapes.

This work is co-funded by the European Commission in the 7th Framework Programme (Thermomag Project, contract NMP4-SL-2011-263207).

### BRIEF DESCRIPTION OF THE FIGURES

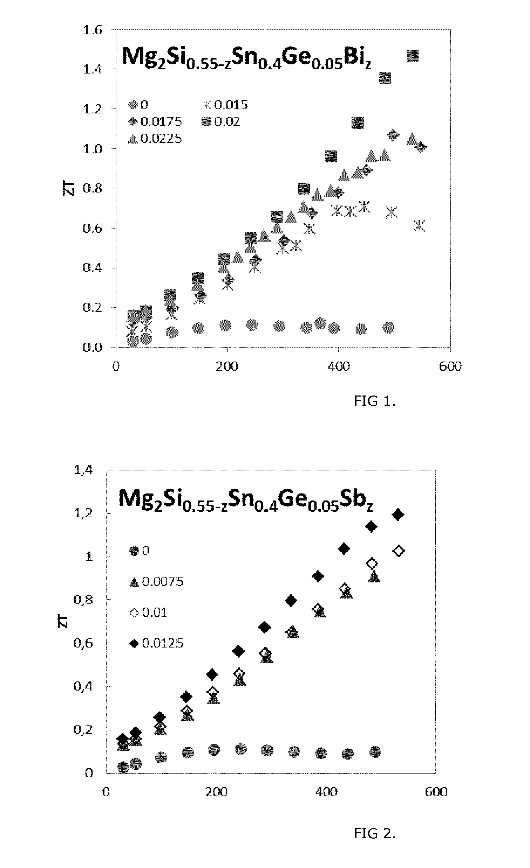

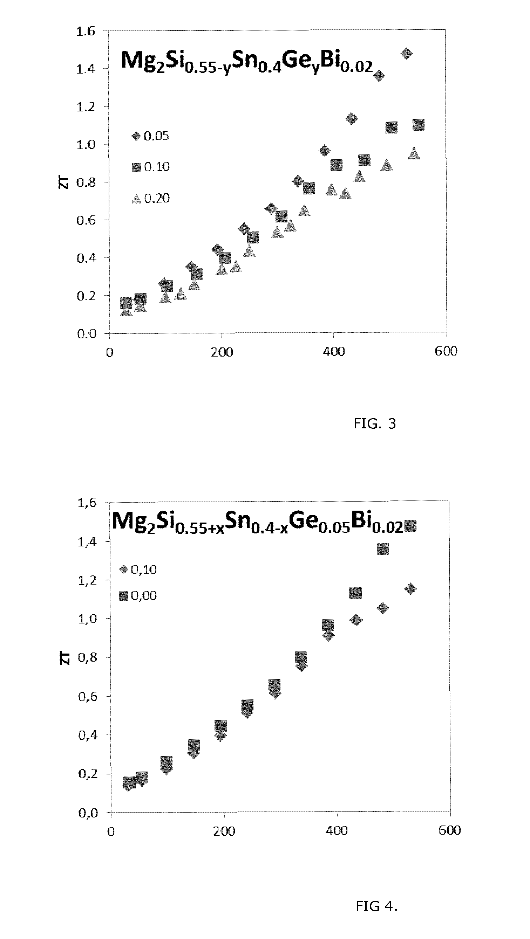

FIGS. 1 to 4 show figure of merit, ZT, data obtained from different materials prepared according to the present invention.

All patent and non-patent references cited in the present application, are hereby incorporated by reference in their entirety.

The invention will now be described in more detail in the following.

### DETAILED DESCRIPTION OF THE INVENTION

According to the present invention, n-type thermoelectric materials with compositions given by the formula Mg₂Si_{0.6+x-y-z}Sn_{0.4-x}Ge_{y}M_{z}, where M is Bi and/or Sb, 0≤x≤0.25, 0<y≤0.15 and 0.005≤z≤0.03 has been identified. N-type thermoelectric materials according to the same formula, but wherein M is Bi and 0.02≤z≤0.025, or wherein M is Sb and 0.01≤z≤0.015, have also been identified.

Materials with compositions given by the above formulae show superior thermoelectric and other properties, including demonstrated ZT values as high as 1.5.

Various powder routes may be used to prepare the n-type quinary materials with compositions given by the formula Mg₂Si_{0.6+x-y-z}Sn_{0.4-x}Ge_{y}M_{z}, where M is Bi and/or Sb, 0≤x≤0.25, 0<y≤0.15 and 0.005≤z≤0.03.

Such methods include those comprising the following steps
- Mixing powders of the elements in proportions appropriate for a desired composition given by the formula Mg₂Si_{0.6+x-y-z}Sn_{0.4-x}Ge_{y}M_{z}, where M is Bi and/or Sb, 0≤x≤0.25, 0<y≤0.15 and 0.005≤z≤0.03;
- Cold pressing the mixed powders;
- Heating to elevated temperatures, e.g., in the range of 600 to 700°C and cooling to room temperature;
- Ball milling the heat treated and cold pressed material;
- Repeating the cold pressing and heating steps at least once;
- Hot-pressing at elevated temperatures and pressures, e.g., in the ranges of 700 to 800°C and 50-100 MPa.

Mixing, cold pressing, ball milling, heat treating and hot pressing are given their standard meanings in the art.

Two non-limiting examples of the method for preparing a desired composition represented by the formula Mg₂Si_{0.6+x-y-z}Sn_{0.4-x}Ge_{y}M_{z}, wherein M may be Bi, Sb or mixture of Bi and Sb, are given below.

Starting elemental powder sizes may vary, and may be in the range of 30µm to 1mm.

Method A comprises the following steps:
- Mixing of elemental powders: powders of Mg, Si, Sn, Ge and M, wherein M may be Bi, Sb or mixture of Bi and Sb, are manually mixed together in proportions according to the desired composition, as represented by the values of x, y and z in the above formula. Approximately 10 atomic % of magnesium in excess of the desired composition may be required to compensate the magnesium loss during processing.
- Cold pressing under pressure: The well-mixed powder is cold pressed under pressure of at least 100 MPa for a time of the order of 2 to 15 minutes.
- Heating of the cold pressed powder: The cold-pressed pellet is sealed in a quartz tube under high vacuum (∼10⁻⁶ Torr). Graphite crucibles may be used to avoid direct contact of the pellet material with the quartz and mitigate loss and/or oxidation of the magnesium. The tube is heated according to the following profile: 600°C for 1 hour, then to 700°C for 1 hour, then to 600°C for 2 hours and cool down to room temperature.
- Ball milling: The material, after the heating step, is ball-milled for 15-60 minutes. This step may improve homogenization and induce nano-scale structural features.
- Repeating the cold pressing and heating steps: During repetition of the cold pressing step, the pressure can be as high as 600 MPa.
- Hot-pressing: The material is finally hot pressed at temperatures 700-800°C and pressure of 50-100 MPa.

Method B comprises the following steps:
- Mixing of elemental powders: same as method A.
- Cold pressing step: same as method A.
- Heating the cold pressed powder: same as method A, except that the tube is heated accorded to the following profile: heat up to 600°C for 1 hour and cool down to room temperature.
- Ball milling step: same as method A.
- Repeat the cold pressing and heating steps: During repetition of the cold pressing step, the pressure may be 300 MPa. During repetition of the heating step, the profile may be 600°C for 1 hour, then to 700°C for 1 hour, then to 600°C for 2 hours and cool down to room temperature.
- Hot-pressing: same as in method A.

The products of these methods are in the form of highly dense pellets with high thermoelectric performance.

Using these methods, materials with overall ZT values reaching 1.5 have been achieved. This is illustrated in the following non-limiting examples shown in FIGS. 1 to 4 for pellets made using method A.
FIG. 1 shows ZT data vs. temperature (°C) for Mg₂Si_{0.55-z}Sn_{0.4}Ge_{0.05}Bi_{z}, for z values of 0, 0.015, 0.0175, 0.02 and 0.0225.
FIG. 2 shows ZT data vs. temperature (°C) for quinary material Mg₂Si_{0.55-z}Sn_{0.4}Ge_{0.05}Sb_{z}, for z values of 0, 0.0075, 0.0125 and 0.015.
FIG. 3 shows ZT data vs. temperature (°C) for quinary material Mg₂Si_{0.55-y}Sn_{0.4}Ge_{y}Bi_{0.02}, for z values of 0.05 and 0.10 and 0.20.
FIG. 4 shows ZT data vs. temperature (°C) for quinary material Mg₂Si_{0.55+x}Sn_{0.4-x}Ge_{0.05}Bi_{0.02}, for z values of 0.0 and 0.10.

To facilitate measurement of TE properties, in these examples, the pellets were prepared in the form of disks, of the order of 10 mm in diameter and typically 2 to 5 mm thick. The ZT data is based on thermal conductivity measurements made using an LFA457, Netzsch apparatus and electrical resistivity and Seebeck Coefficient measurement performed using an ULVAC-ZEM3 system. Other pellet shapes and sizes could be used.

Pellets made according to the above methods and/or having the properties listed in the above examples could be incorporated into the n-type part of a TE device comprising an n-type part and a p-type part, in which one or more pairs of the n-type and p-type parts are in electrical series and disposed in parallel with respect to an actual or induced temperature difference. The pellets may be formed in appropriate shape for a given TE device or may be cut to shape.

In order to improve stability and useful lifetime, pellets may be coated with a layer of boron nitride using standard techniques, such as spraying or sputtering from a boron nitride target in an Ar atmosphere.

Although the present invention has been described in connection with the specified embodiments, it should not be construed as being in any way limited to the presented examples. The scope of the present invention is set out by the accompanying claim set. In the context of the claims, the terms "comprising" or "comprises" do not exclude other possible elements or steps. Also, the mentioning of references such as "a" or "an" etc. should not be construed as excluding a plurality. The use of reference signs in the claims with respect to elements indicated in the figures shall also not be construed as limiting the scope of the invention. Furthermore, individual features mentioned in different claims, may possibly be advantageously combined, and the mentioning of these features in different claims does not exclude that a combination of features is not possible and advantageous.

## Claims

1. A thermoelectric n-type material comprising at least one compound represented by the formula Mg₂Si_{0.6+x-y-z}Sn_{0.4-x}Ge_{y}M_{z}, wherein M is Bi, Sb or mixture of Bi and Sb, and wherein 0<x≤0.25, 0<y≤0.15 and 0.005<z≤0.03.

2. The thermoelectric n-type material of claim 1, wherein M is Bi and 0.02≤z≤0.025.

3. The thermoelectric n-type material of claim 1, wherein M is Sb and 0.01≤z≤0.015.

4. A process for the preparation of the material according to any of claims 1 to 3, comprising the following steps:
mixing powders of the elements Mg, Si, Sn and Ge, and Bi and/or Sb, in proportions appropriate for the desired composition;
cold pressing the mixed powders;
heating the cold pressed powder to a temperature in the range of 600 to 700°C and cooling to room temperature;
ball milling the heat treated material:
repeating the cold pressing and heating steps at least once; and,
hot-pressing at temperatures in the range of 700 to 800°C in the range of 50-100 MPa.

5. The process according to claim 4, further comprising, in the step of cold pressing, applying a pressure of around 100 MPa for 2 to 15 minutes.

6. The process according to claim 4 or 5, further comprising, in the step of ball milling, ball milling for 15-60 minutes.

7. The process according to any of claims 4 to 6, further comprising, in the step of heating the cold pressed powder, heating to 600°C for one hour, heating to 700°C for one hour and 600°C for two hours, before cooling to room temperature.

8. The process according to any of claim 7, further comprising, in the step of repeating the cold pressing and heating steps, increasing the pressure in the cold pressing step to 600 MPa.

9. The process according to any of claims 4 to 6, further comprising, in the step of heating the cold pressed powder, heating to 600°C for one hour before cooling to room temperature.

10. The process according to claim 9, further comprising, in the step of repeating the cold pressing and heating steps, increasing the pressure in the cold pressing step to 300 MPa.

11. The process according to claim 9, further comprising, in the step of repeating the cold pressing and heating steps, in the step of heating the cold pressed powder, heating to 600°C for one hour, heating to 700°C for one hour and 600°C for two hours, before cooling to room temperature.

12. In the process of any of claims 1 to 11, in the step of mixing the elemental powders, increasing the amount of Mg by up to approximately 10 atomic percent to accommodate for losses and/or oxidation during processing.

13. In the process of any of claims 1 to 12, following the step of hot pressing, applying a boron nitride coating.

14. A thermoelectric device comprising an n-type part and a p-type part **characterized in that** said n-type part comprises a material according to any of claims 1 to 3.

15. The thermoelectric device of claim 14, wherein the thermoelectric material is prepared according to the process of any of claims 4 to 13.
